# EUROPEAN PATENT SPECIFICATION

(11) **EP 0 345 767 B1**
(45) Date of publication and mention of the grant of the patent: **19.01.1994**
(21) Application number: 89110347.5
(22) Date of filing: 08.06.1989
(51) Int. Cl.: H01L 39/16, H01B 12/00

(54) **Fault current limiter**
Anordnung zur Überstrombegrenzung
Dispositif pour limiter l'excès de courant

(30) Priority: 10.06.1988 SE 8802172
(43) Date of publication of application: 13.12.1989
(73) Proprietor: ASEA BROWN BOVERI AB, 721 83 Västeras (SE)
(72) Inventor: Bergsjö, Nils-Johan, S-72348 Västeras (SE); Liljestrand, Lars, S-722 42 Västeras (SE)
(74) Representative: Boecker, Joachim, Dr.-Ing.

(56) References cited:
- DD-A- 119 924
- DE-A- 2 712 990
- CHEMICAL AND ENGINEERING NEWS (C & EN), vol. 65 ab. 19, May 11, 1987, "Superconductivity : A Revolution In Electricity Is Taking Shape", pp. 7-16.

## Description

The invention relates to a fault current limiter according to the precharacterising part of claim 1.

Short circuits on power networks may cause great damage. It is therefore desirable to be able rapidly to limit both the amplitude and duration of the short circuit currents which may occur. Available sensing means and circuit-breakers have a time delay corresponding to a few cycles before the current can be broken. Because of the generally relatively large mechanical masses that have to be actuated when a line circuit-breaker is to open, it is difficult to attain shorter break times. A generally known way of rapidly reducing a short circuit current is to connect a current limiting element in series with a circuit breaker. Different current limiting elements are available, among them those based on the use of superconductors and a current limiting resistor.

A superconductive material is dependent on three parameters to achieve or maintain its superconducting state. If any of these parameters exceeds a critical value, the superconducting state ceases and the material resumes its normal conducting state. The three parameters are temperature, current density and magnetic flux density. All three parameters have been used to achieve the desired current limitation. An example of how to use several of the critical parameters in combination in order to produce a current limiter is described in an article in Journal of Applied Physics, 49 (4), April 1978, pages 2546-2550 by K E Gray and D Fowler entitled "A superconducting fault-current limiter". This current limiter comprises two parallel-connected resistors. One resistor consists of a material which may become superconducting and which is located in a cryostat, i.e. a cryotank, in which the low temperature which is necessary to obtain a superconducting state can be attained, while at the same time the resistor is dimensioned such that the current at which the current limiter is to enter into operation gives a current density which is well below the critical density and such that also the normally surrounding magnetic flux density is lower than the critical flux density.

In the embodiment described in the above-mentioned article, the resistance is changed from practically zero at the superconducting state to the order of magnitude of 13 kΩ when the superconducting state ceases. The second resistor is dimensioned such that its resistance is considerably lower than the resistance of the superconductive resistor in its non-superconducting state. In the case referred to the resistance is about 3.6 Ω. The equipment involved in the prior current limiter described in the Journal of Applied Physics is very complex.

Under normal circumstances of the network, the superconductive resistor is kept in a superconducting state, i.e. its resistance is close to zero causing the current to flow only through this resistor and producing no mentionable voltage drop across the two parallel-connected resistors. Now, if the mains current, because of a short-circuit or otherwise, exceeds a predetermined value at which the current limiter is desired to start operating, the superconductive resistor in the described device is affected by a magnetic field which partially changes the magnetic flux density around the conductor, thus effecting a partial increase of the resistance which also results in an increase of the temperature in the resistor. Before long this will lead to the superconducting state being terminated thus forcing a predominant part of the current through the parallel-connected ordinary resistor.

Only using the critical current density to cause a superconductive material to pass from the superconducting to the non-superconducting state is described in the DE-A-2 712 990. This document describes a current limiter in the form of a "superconducting cable" consisting of conductors of a material that may become superconducting and of conductors ("Matrix-/Trägermetall") dimensioned such that the superconducting cable constitutes a current-limiting element when the parallel-connected superconducting conductor is no longer superconducting. The superconducting conductor(s) is (are) formed with certain regions having reductions in cross-section ("Einschnürungen") where the critical current density is exceeded when the current carried through the cable exceeds the current at which the current limiter is to become responsive. One problem in connection with the superconducting cable, which is not addressed in the DE-A-2 712 990, is what happens to the heat developed in the cable when it changes from superconducting to normally conducting state.

The invention aims at developing a fault current limiter of the above-mentioned kind, which is of relatively simple design, exhibits high functional accuracy, is insensitive to local defects in the superconductive material, and can be manufactured in a relatively simple manner.

To achieve this aim the invention suggests a current limiter according to the introductory part of claim 1, which is characterized by the features of the characterizing part of claim 1.

Further developments of the invention are characterized by the features of the additional claims.

In principle, the invention is a variant to the above-described fault current limiter disclosed in the "Journal of Applied Physics". Thus, a fault current limiter according to the invention comprises two parallel-connected resistors, the first one consisting of a material which may become superconducting. In a superconducting state, thus, the second resistor is virtually short-circuited and no voltage drop appears across the combination of resistors. The second resistor has a resistance which is considerably lower than the resistance of the superconductive resistor in its non-superconducting state. However, it should have a resistance which is of such a magnitude that the current in the circuit in question does not grow too large. However, here ends the similarity between the prior art and a current limiter according to the invention.

A fault current limiter according to the invention comprises two resistor layers. A first layer consists of a material that may become superconducting. A second layer consists of normally conducting material which is applied on the first layer by vapour deposition, plasma spraying, or otherwise. The second layer is dimensioned such that its resistance is considerably lower than the resistance of the superconducting layer in its non-superconducting state. However, the second layer is to be dimensioned such that, when the first layer is no longer superconducting, the resistance will limit the overcurrent to a permissible value.

The connection of the fault current limiter takes place by means of the connection devices attached to the second resistor layer.

Since the combination of resistors will be both thin and brittle, a mechanical base for these two layers is needed. The base may conveniently consist of an insulating material on which the superconducting material is applied. This can be done, for example, by sputtering or another technique, which permits the superconducting layer to be evenly distributed on the insulator and which also permits the layer to become sufficiently thin.

Principally it can also be the ordinary resistance layer that is applied directly on the supporting insulating body, with the superconducting resistor layer being applied on top of the ordinary resistor layer. However, preference is given to the embodiment with the superconductive layer applied directly on the insulator. One reason for this is that this layer is usually considerably thinner than the ordinary resistor layer so that the latter also may provide mechanical protection for the thin superconducting layer. The width of the superconductive layer may be as small as 15 to 20 micrometers.

There are generally no demands imposed on the kind of material selected for either resistive layer. However, such materials are to be preferred that can be applied by vapor deposition, sputtering, plasma spraying and similar techniques. These materials include, among others, the so-called HTSC-compounds (high temperature superconducting materials).

In a current limiting device according to the invention, the two resistance layers, the insulator, and the connecting parts are to be situated in a cryostat.

The critical parameter which according to the invention is used to achieve the transition from superconducting to non-superconducting state is the current density. By forming the superconductive material as a thin layer, there are no problems in dimensioning the cross-sectional area of the layer so as to attain the critical current density at the current value the current limiter is intended to become effective.

A current limiter according to the invention may also consist of current limiting elements with several layers of superconducting materials alternating with resistance material.

The fault current limiter according to the invention can also be formed with series-connected elements with successively increasing critical currents. In this way, a smooth transition between the superconducting and the normally conducting state can be achieved, i.e. in practice a current-dependent current limiter.

A considerable advantage with a fault current limiter according to the invention is that problems with possible local defects in the superconductive material are eliminated. Since the current limiter consists of two separate and different resistors, the superconductor can be destroyed because of the temperature increase which is obtained in case of local defects. With a current limiter according to the invention, in the event of any local defects the current will be able to be carried in the second resistance layer.

Upon a short-circuit on the network, the current limiter will limit the current until the line circuit-breaker opens. During this period, the current limiter will absorb the energy developed, which is dependent upon the amplitude and duration of the current and the resistance of the second resistor. This energy effects a rise in temperature, which has to be remedied by the supply of additional coolant.

By way of example, the invention will now be described in greater detail with reference to the accompanying drawings showing in
- Figure 1: a preferred embodiment of a fault current limiter according to the invention,
- Figure 2: an alternative embodiment of the invention,
- Figure 3: a current limiter according to the invention with several layers of alternately superconductive and ordinary resistance materials,
- Figure 4: a further embodiment of the invention with alternately applied layers.

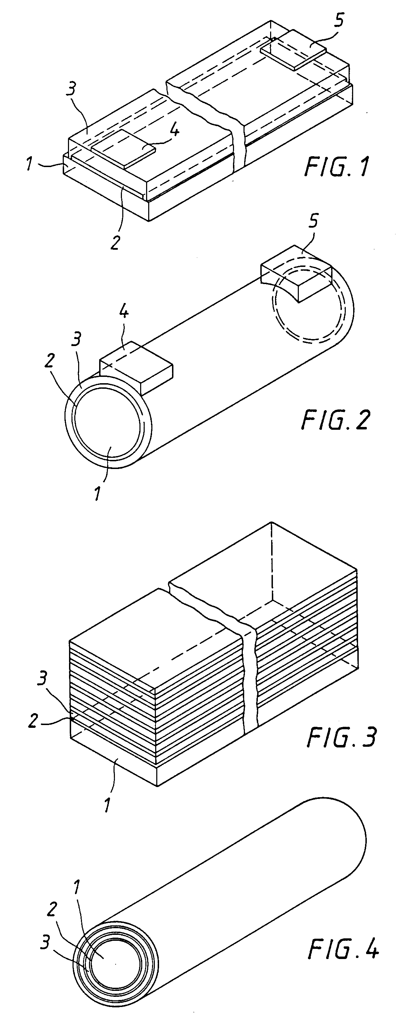

The dimensioning of the parts included in the fault current limiter with respect to the cross-sectional area of the superconductive first resistance layer in order to obtain transition at the critical current, the choice of material for the second resistance layer and the cross-sectional area of this layer, the necessary length of the resistors, the temperature increases, the developed heat energy, the need of coolant, and so on, are, of course, dependent on the properties of the available materials at the time of construction, the currents occurring, etc., and will therefore not be described here. As will have been clear from the foregoing, the invention comprises the design of the fault current limiter. A preferred embodiment is shown in Figure 1. On a supporting insulator 1 shaped as a rod with rectangular cross-section, there is applied on one side, by means of sputtering or the like, a first thin layer 2 of superconductive material. The shunt resistance 3, consisting of a suitable resistance material, is applied by vapour deposition, plasma spraying, or in some other way, on top of the superconducting material. This second resistance layer is provided with connection means 4 and 5.

An alternative embodiment comprises applying a superconductive layer on two opposing sides of a bar of insulating material, with layers of the second resistance material applied on top of the superconductive layers.

In an alternative according to Figure 2, the supporting insulator 1 consists of a cylindrical rod or a tube on which the two resistance layers are applied on top of each other.

The supporting insulator may, of course, otherwise have a number of different embodiments which are covered by the invention.

Figure 3 shows schematically how several alternating layers of superconductive material and ordinary resistance material are applied one above the other.

Figure 4 shows how the technique using alternating layers is carried out by using a cylindrical supporting insulator 1. When dimensioning the different layers, special attention must be paid to the fact that the radius increases for each new layer.

As described above, the current limiter can be designed as a series connection of current-limiting elements with a rising critical current, whereby a current-dependent current limiter characteristic can be obtained.

## Claims

1. A fault current limiter comprising a first resistor (2) consisting of superconductive material, a second resistor (3) with a resistance considerable lower than the resistance of the superconductive resistor in its non-superconducting state, an insulator (1) for mechanical support of the resistors, and a cryotank, **characterized** in
- that one of the resistor, preferably said first resistor, is applied as a layer (2) on said insulator (1),
- that the other resistor is applied as a layer (3) on top of the afore-mentioned resistor layer (2),
- that the resistor layer consisting of the superconducting material is dimensioned such that at the current limit at which the current limiter is to become effective the current density in the material of this resistor layer arrives at its critical value,
- that the second resistor layer (3) is dimensioned such that its resistance reduces a possible over-current to a predetermined value,
- that one of the resistor layers, preferably the outermost resistor layer, is provided with current connection means (4, 5),
- and that the insulator and the resistors are placed in said cryotank.

2. A fault current limiter according to claim 1, **characterized** in that the insulator (1) is shaped as a bar of rectangular cross-section, and that one of the resistors, preferably the superconducting resistor, is applied on one side of said bar and that the other resistor is applied on top of the afore-mentioned resistor.

3. A fault current limiter according to claim 1, **characterized** in that the insulator (1) is shaped as a bar of rectangular cross-section, that one of the resistors, preferably the superconducting resistor, is applied on opposite sides of the bar, and that the other resistor is applied on the top of the first-mentioned resistor layer.

4. A fault current limiter according to claim 1, **characterized** in that the insulator (1) is shaped as a cylindrical rod, that one of the resistors, preferably the superconducting resistor, is applied on the envelope surface of said rod, and that the other resistor is applied on the top of the first-mentioned resistor layer.

5. A fault current limiter according to claim 1, **characterized** in that the insulator (1) is shaped as a tube, that one of the resistors, preferably the superconducting resistor, is applied on the envelope surface of said tube, and that the other resistor is applied on top of the first-mentioned resistor layer.

6. A fault current limiter according to any of the preceding claims, **characterized** in that several layers of the two resistors are applied alternately one above the other.

7. A fault current limiter according to any of the preceding claims, **characterized** in that a plurality of said current limiters are connected in series, and that the first resistor comprising the superconducting material has different cross-sectional areas in all series-connected current limiters.

8. A fault current limiter according to any of the preceding claims, **characterized** in that the superconducting material consists of high temperature superconductive materials (HTSC-compounds).

## Patentansprüche

1. Überstrombegenzer mit einem ersten Widerstand (2) aus supraleitfähigem Material, mit einem zweiten Widerstand (3) mit einem bedeutend kleineren Widerstandswert als der Widerstandswert des supraleitfähigen Widerstandes in seinem nicht-supraleitfähigen Zustand, mit einem Isolator (1) als mechanischem Träger für die Widerstände, und mit einem Kältetank, **dadurch gekennzeichnet**,
- daß einer der Widerstände, vorzugsweise der genannte erste Widerstand, als eine Schicht (2) auf dem genannten Isolator (1) aufgebracht ist,
- daß der andere Widerstand als eine Schicht (3) auf der vorgenannten Widerstandsschicht (2) aufgebracht ist,
- daß die aus supraleitfähige Material bestehende Widerstandsschicht so bemessen ist, daß bei der Stromgrenze, bei welcher der Strombegrenzer ansprechen soll, die Stromdichte in dem Material dieser Widerstandsschicht ihren kritischen Wert erreicht,
- daß die zweite Widerstandsschicht (3) so bemessen ist, daß ihr Widerstandswert einen möglichen Überstrom auf einen vorbestimmten Wert reduziert,
- daß eine der Widerstandsschichten, vorzugsweise die äußerste Widerstandsschicht, mit Stromanschlußvorrichtungen (4, 5) versehen ist,
- und daß der Isolator und die Widerstände in dem genannten Kältetank angeordnet sind.

2. Überstrombegenzer nach Anspruch 1, **dadurch gekennzeichnet**, daß der Isolator (1) die Form eines Stabes mit rechteckigen Querschnitt hat und daß einer der Widerstände, vorzugsweise der supraleitfähige Widerstand, auf einer Seite des genannten Stabes aufgebracht ist und daß der andere Widerstand auf dem erstgenannten Widerstand aufgebracht ist.

3. Überstrombegenzer nach Anspruch 1, **dadurch gekennzeichnet**, da der Isolator (1) die Form eines Stabes mit rechteckigem Querschnitt hat, daß einer der Widerstände, vorzugsweise der supraleitfähige Widerstand, auf gegenüberliegenden Seiten des Stabes aufgebracht ist und daß der andere Widerstand auf den erstgenannten Widerstandsschichten aufgebracht ist.

4. Überstrombegenzer nach Anspruch 1, **dadurch gekennzeichnet**, daß der Isolator (1) die Form eines zylindrischen Stabes hat, daß einer der Widerstände, vorzugsweise der supraleitfähige Widerstand, auf der Mantelfläche des Stabes aufgebracht ist und daß der andere Widerstand auf der erstgenannten Widerstandsschicht aufgebracht ist.

5. Überstrombegenzer nach Anspruch 1, **dadurch gekennzeichnet**, daß der Isolator (1) als Rohr ausgebildet ist, daß einer der Widerstände, vorzugsweise der supraleitfähige Widerstand, auf der Mantelfläche des genannten Rohres aufgebracht ist und daß der andere Widerstand auf der erstgenannten Widerstandsschicht aufgebracht ist.

6. Überstrombegenzer nach einem der vorhergehenden Ansprüche, **dadurch gekennzeichnet**, daß mehrere Schichten der beiden Widerstände abwechselnd übereinander aufgebracht sind.

7. Überstrombegenzer nach einem der vorhergehenden Ansprüche, **dadurch gekennzeichnet**, daß eine Mehrzahl der genannten Strombegrenzer in Reihe geschaltet ist, und daß der erste Widerstand, welcher das supraleitfähige Material enthält, unterschiedliche Querschnittsflächen in allen in Reihe geschalteten Strombegrenzern hat.

8. Überstrombegenzer nach einem der vorhergehenden Ansprüche, **dadurch gekennzeichnet**, daß das supraleitfähige Material aus einem supraleitfähigen Material für hohe Temperaturen besteht (HTSC-Vernindungen).

## Revendications

1. Un limiteur de courant de défaut comprenant une première résistance (2) consistant en un matériau supraconducteur, une seconde résistance (3) ayant une valeur de résistance considérablement inférieure à la valeur de la résistance supraconductrice dans son état non supraconducteur, un isolant (1) pour le support mécanique des résistances, et une cuve cryogénique, **caractérisé** en ce que
- l'une des résistances, de préférence la première résistance, est appliquée sous la forme d'une couche (2) sur l'isolant (1),
- l'autre résistance est appliquée sous la forme d'une couche (3) sur la surface supérieure de la couche de résistance précitée (2),
- la couche de résistance qui est constituée par le matériau supraconducteur est dimensionnée de façon qu'au courant limite auquel le limiteur de courant doit entrer en fonction, la densité de courant dans le matériau de cette couche de résistance atteigne sa valeur critique,
- la seconde couche de résistance (3) est dimensionnée de façon que sa valeur de résistance réduise à une valeur prédéterminée une surintensité possible,
- l'une des couches de résistances, de préférence la couche de résistance la plus extérieure, est munie de moyens de connexion (4, 5) pour le passage du courant,
- et l'isolant et les résistances sont placés dans la cuve cryogénique.

2. Un limiteur de courant de défaut selon la revendication 1, **caractérisé** en ce que l'isolant (1) a la forme d'une barre de section droite rectangulaire, et en ce que l'une des résistances, de préférence la résistance supraconductrice, est appliquée sur une face de la barre, et l'autre résistance est appliquée sur la résistance mentionnée en premier.

3. Un limiteur de courant de défaut selon la revendication 1, **caractérisé** en ce que l'isolant (1) a la forme d'une barre de section droite rectangulaire, l'une des résistances, de préférence la résistance supraconductrice, est appliquée sur des faces opposées de la barre, et l'autre résistance est appliquée sur les couches de résistances mentionnées en premier.

4. Un limiteur de courant de défaut selon la revendication 1, **caractérisé** en ce que l'isolant (1) a la forme d'un barreau cylindrique, l'une des résistances, de préférence la résistance supraconductrice, est appliquée sur la surface d'enveloppe de ce barreau, et l'autre résistance est appliquée sur les couches de résistances mentionnées en premier.

5. Un limiteur de courant de défaut selon la revendication 1, **caractérisé** en ce que l'isolant (1) a la forme d'un tube, l'une des résistances, de préférence la résistance supraconductrice, est appliquée sur la surface d'enveloppe de ce tube, et l'autre résistance est appliquée sur la couche de résistance mentionnée en premier.

6. Un limiteur de courant de défaut selon l'une quelconque des revendications précédentes, **caractérisé** en ce que plusieurs couches des deux résistances sont appliquées alternativement l'une sur l'autre.

7. Un limiteur de courant de défaut selon l'une quelconque des revendications précédentes, **caractérisé** en ce que plusieurs des limiteurs de courant sont connectés en série, et en ce que la première résistance constituée par le matériau supraconducteur a des aires de section droite différentes dans tous les limiteurs de courant connectés en série.

8. Un limiteur de courant de défaut selon l'une quelconque des revendications précédentes, **caractérisé** en ce que le matériau supraconducteur consiste en matériaux supraconducteurs à température élevée (composés HTSC).
